# EUROPEAN PATENT APPLICATION

(11) **EP 1 174 723 A1**
(43) Date of publication of application: **23.01.2002**
(21) Application number: 01116745.9
(22) Date of filing: 19.07.2001
(51) Int. Cl.: G01R 31/316

(54) **Temperature control apparatus**

(30) Priority: 19.07.2000 JP 2000219784
(71) Applicant: TOKYO ELECTRON LIMITED, Minato-ku, Tokyo 107-8481 (JP)
(72) Inventor: Yonezawa, Toshihiro, Intellectual Property Dept., Minato-ku, Tokyo 107-8481 (JP); Tsukada, Hiroshi, Intellectual Property Dept., Minato-ku, Tokyo 107-8481 (JP)
(74) Representative: HOFFMANN - EITLE

(57) **Abstract**

There is disclosed a wafer temperature control apparatus (10) comprising a heater (13) for heating a wafer chuck (12), a cooler (14) which contacts the heater (13) via seal members (19, 19A), a temperature sensor (16) passed through the heater and cooler to enter a concave portion (12A) of the wafer chuck (12), and a PID controller (17) for controlling the heater (13) in accordance with a detected temperature of the temperature sensor (16). A connection hole (14B) connected to a gap δ formed between the heater (13) and the cooler (14) via the seal members (19, 19A) is formed in the cooler (14), and connected to a vacuum pump (21) via a changeover valve (22). Additionally, when the changeover valve (22) is controlled via the PID controller (17) to set a pressure of the gap δ to a reduced pressure or an atmospheric pressure, the cooler (14) is attached to or detached from the heater (13).

## Description

The present invention relates to a temperature control apparatus, particularly to a temperature control apparatus of objects to be heated such as a wafer, more preferably to a wafer temperature control apparatus for use in a reliability test.

In a semiconductor test process, respective electric properties of a large number of integrated circuits (hereinafter referred to as "chip") formed on a semiconductor wafer (hereinafter referred to as "wafer") are tested, and a chip having no electrical defects is screened. The screened satisfactory chip is packaged by synthetic resin or a ceramic in an assembly process. In a reliability test, a thermal or electric stress is applied to the packaged product, and potential defects or the like of the chip are clarified. As a result, defective materials are removed.

With the miniaturization and function enhancement of electric products, chips have been miniaturized and highly integrated. In recent years, various mounting techniques have been developed in order to further miniaturize semiconductor products. As a result, a technique of mounting a non-packaged chip, that is, a so-called bare chip has been developed. When a bare chip is put on the market, the quality must be guaranteed. Reliability tests have to be carried out on them in order to put them on the market.

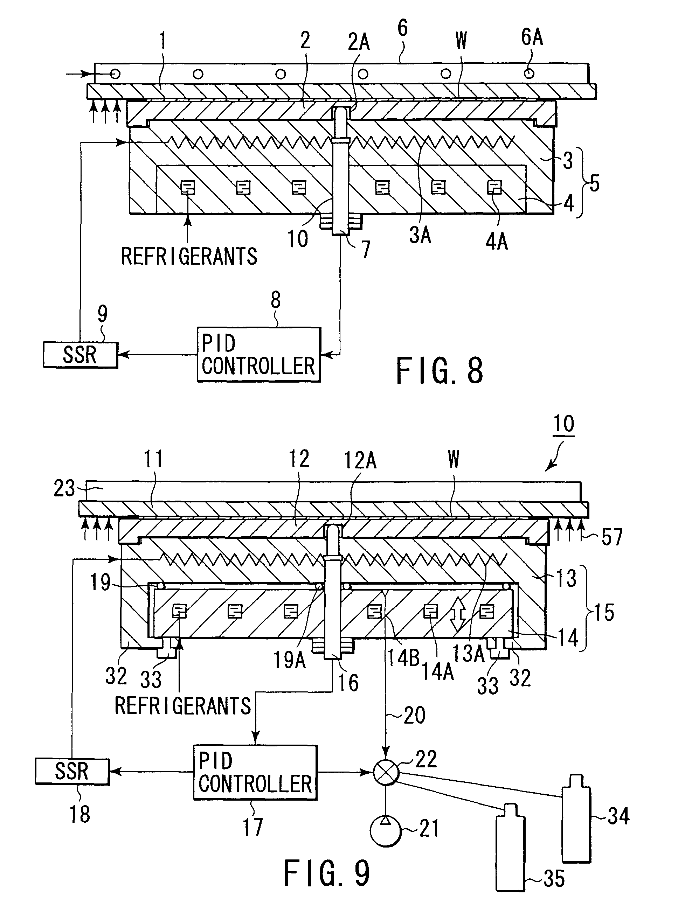

In U.S. Patent No. 6,084,215, the present applicant has proposed a reliability test apparatus which can test the chip still in a wafer state. Particularly, in this publication, a wafer temperature control apparatus is proposed which can accurately grasp and stabilize a test temperature during the reliability test of the chip still in the wafer state. The wafer temperature control apparatus will be described with reference to FIG. 8. The wafer temperature control apparatus includes a contacter 1, a wafer holder 2 (hereinafter referred to as "wafer chuck") for holding a semiconductor wafer W, a heater 3 for contacting a back surface of the wafer chuck 2 to heat the wafer chuck 2, and a cooler 4 (hereinafter referred to as "cooling jacket") integrally formed with the heater 3. The heater 3 has therein a heat generator 3A constituted of a heating coil, heating plate, or the like, and the cooling jacket 4 has therein a channel 4A through which refrigerants such as water and ethylene glycol circulate. The heater 3 is formed integrally with the cooling jacket 4 to form a bottom jacket 5. An upper surface of the contacter 1 is coated with a top jacket 6. The contacter 1 is cooled by the refrigerant which circulates in a channel 6A formed in the top jacket 6. A plurality of through holes 10 (FIG. 7 shows only one through hole) are formed in the bottom jacket 5. A temperature sensor 7 is attached to these through holes. A concave portion 2A is formed opposite to the through hole in the back surface of the wafer chuck 2. The temperature sensor 7 is inserted in the concave portion 2A, and connected to a PID controller 8. The PID controller 8 controls and turns on/off the heat generator 3A via a relay 9 based on the detected temperature of the temperature sensor 7.

To test the reliability of the wafer W, the heat generator 3A generates heat, the wafer W is heated via the wafer chuck 2, and the temperature of the wafer W rises to a set temperature (e.g., 150°C). During this, the refrigerant circulates in the channels 4A, 6A of the cooling jacket 4 and top jacket 6, and reduces the temperature rise in the periphery of the reliability test apparatus.

In the wafer temperature control apparatus, the heater is formed integrally with the cooling jacket. Therefore, even while the object to be heated (e.g., wafer W) is heated by the heater, the heating efficiency of the heater is deteriorated, response to temperature control is impaired, and the temperature of the wafer W cannot rapidly be controlled because of a cooling action by the cooling jacket. Additionally, the heat generator is constantly cooled by the cooling jacket, and a heating temperature by the heat generator is disadvantageously limited to a range narrower than a temperature range in which the temperature can originally rise.

The present invention has been developed to solve the aforementioned problem.

One object of the present invention is to efficiently use a heat generator during reliability testing and save on heating energy.

Another object of the present invention is to enhance a response to temperature control, and rapidly control the temperature of an object to be heated (e.g., wafer).

A further object of the present invention is to provide a temperature control apparatus in which a temperature range able to be controlled by the heat generator is broadened and temperature can continuously be controlled in a broad range.

According to a first aspect of the present invention, there is provided a temperature control apparatus comprising: an object whose temperature is controlled; a heating member, disposed substantially in contact with the object, for heating the object; a cooling member, disposed opposite to the heating member with respect to the object, for cooling the object via the heating member; at least one temperature sensor for detecting a temperature of the object; a controller for controlling the temperature of the heating member and the cooling member based on the temperature detected by the temperature sensor; and a heat flow rate control mechanism for appropriately controlling a heat flow rate between the heating member and cooling member.

The heat flow rate control mechanism of the temperature control apparatus preferably comprises a cooling member movement mechanism for moving the cooling member with respect to the heating member, and bringing the cooling member in contact with the heating member, or forming a gap between the cooling member and the heating member.

The object of the temperature control apparatus is preferably a semiconductor wafer.

The cooling member movement mechanism preferably comprises a seal member disposed between the heating member and the cooling member, and an exhaust mechanism connected to a space between the heating member and the cooling member via a changeover valve.

At least one of the heating member and the cooling member in the temperature preferably comprises a groove for containing the seal member.

The cooling member movement mechanism in the temperature control apparatus preferably comprises a mechanism for moving the cooling member by an electromotive mechanism.

The cooling member movement mechanism in the temperature preferably comprises a movement mechanism comprising a seal member disposed between the heating member and the cooling member and an exhaust mechanism connected to a space between the heating member and the cooling member via a changeover valve, and a mechanism for moving the cooling member by an electromotive mechanism.

The controller in the temperature control apparatus preferably comprises a PID adjusting meter.

The temperature control apparatus further comprises a chuck top comprising a laying surface on which the object is to be laid and a lower surface which contacts the heating member.

At least a tip end of the temperature sensor is preferably disposed in a concave portion formed in a lower surface of the chuck top.

The heating member and the cooling member in the temperature control apparatus are disposed with a gap therebetween, and the heat flow rate control mechanism comprises a mechanism for bringing the gap between the heating member and the cooling member to at least one of a state filled with a high heat conductive gas, a state filled with a low heat conductive gas, and an evacuated state.

This summary of the invention does not necessarily describe all necessary features so that the invention may also be a sub-combination of these described features.

The invention can be more fully understood from the following detailed description when taken in conjunction with the accompanying drawings, in which:

FIG. 1 is a sectional view showing one embodiment of a wafer temperature control apparatus according to the present invention.

FIG. 2 is a sectional view showing another embodiment of the wafer temperature control apparatus according to the present invention.

FIG. 3 is a sectional view showing another embodiment of the wafer temperature control apparatus according to the present invention.

FIG. 4 is a perspective view for bringing a shell into a wafer containing chamber in which the wafer temperature control apparatus of the present invention is contained.

FIG. 5 is an explanatory view for transmitting/receiving a signal during a reliability test in the wafer containing chamber shown in FIG. 4.

FIGS. 6A, 6B, 6C and 6D are diagrams showing a wafer chuck for use in the wafer temperature control apparatus according to the present invention. FIG. 6A is a perspective view of the wafer chuck, FIG. 6B is a main sectional view of the wafer chuck, FIG. 6C is a sectional view showing a valve mechanism of a gas supply/exhaust tube, and FIG. 6D is a perspective view showing a seal member for use in a main part shown in FIG. 6B.

FIG. 7 is a sectional view showing another embodiment of the temperature control apparatus of the present invention.

FIG. 8 is a diagram showing one example of a conventional wafer temperature control apparatus.

FIG. 9 is a sectional view showing another embodiment of the temperature control apparatus according to the present invention.

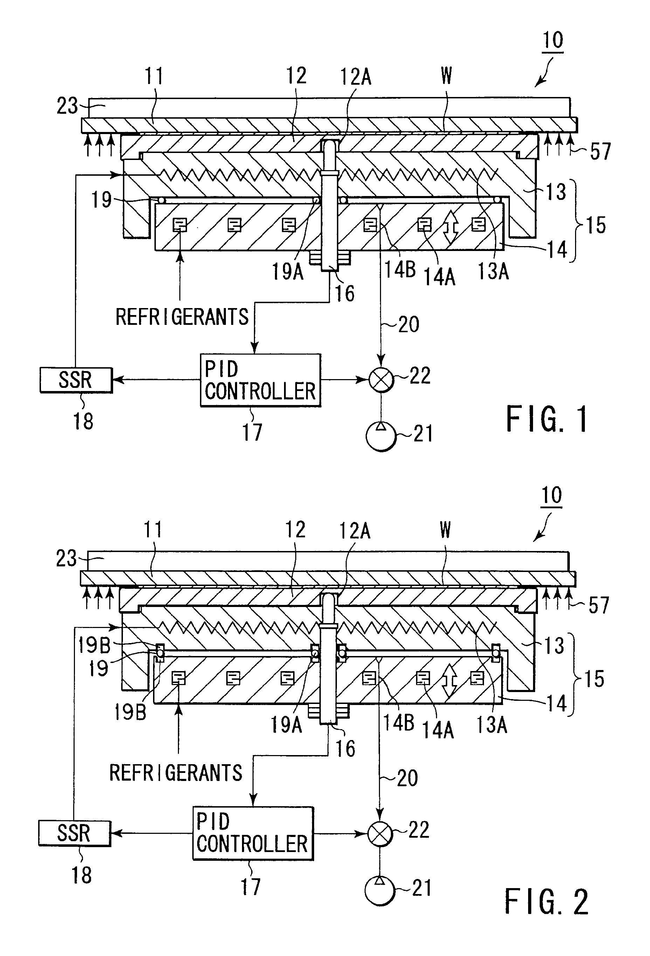

Preferred embodiments of the present invention will be described hereinafter with reference to FIGS. 1 to 9. An object whose temperature is controlled in a temperature control apparatus of the present invention includes various components/products. Here, for the sake of convenience of description, a case in which the object is a semiconductor wafer will be described.

A wafer temperature control apparatus 10 of an embodiment is an apparatus for controlling a temperature of a semiconductor wafer W in contact with a lower surface of a wafer chuck 12 while the reliability of a chip in a wafer state is tested in a burn-in test or the like, for example, as shown in FIG. 1. The wafer chuck 12 holds the semiconductor wafer W collectively in contact with a contacter 11. The wafer temperature control apparatus 10 includes: a heater 13 for heating the wafer chuck 12; a cooler 14 disposed in the vicinity of the heater 13; a temperature sensor 16 for measuring the temperature of the wafer chuck 12 disposed through a bottom jacket 15 constituted of the heater 13 and cooler 14; a controller (e.g., PID controller) 17 for controlling the temperature of the heater 13 and cooler 14 based on the temperature detected by the temperature sensor 16; a relay 18; a through hole 14B; a piping 20; a changeover valve 22; and a vacuum pump 21. The temperature sensor 16 is preferably disposed and inserted in a concave portion 12A formed in the lower surface of the wafer chuck 12.

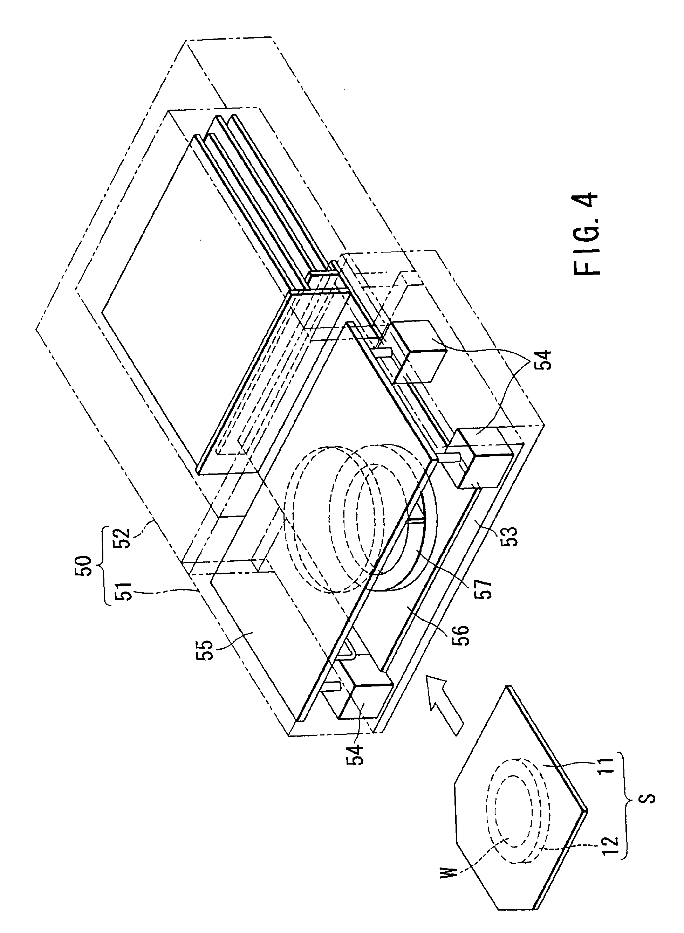

The temperature control apparatus can be contained in a wafer containing chamber 50 shown in FIG. 4. The wafer W held between the contacter 11 and the wafer chuck 12 can be introduced into or out of the wafer temperature control apparatus 10 in an integrated state. A collective contact state of the wafer W with the contacter 11 indicates a state in which respective testing electrodes (hereinafter referred to as "electrode pad") of a large number of chips formed on the whole surface of the wafer are collectively brought in contact with protruding testing terminals (hereinafter referred to as "contact") disposed on the contacter 11, and the electrode pads are electrically connected to the contacts. An integrated state of the wafer W, contacter 11 and wafer chuck 12 will be described later. The integrated wafer W, contacter 11 and wafer chuck 12 will hereinafter be referred to as a shell S for the sake of convenience.

The heater 13 has a heat generator 13A. The cooler 14 can be cooled by a refrigerant which flows through a channel 14A. At least one through hole can be formed in a center of the heater 13 and cooler 14. The cylindrical temperature sensor 16 is passed through the through hole, and an upper end of the sensor projects from the upper surface of the heater 13. The temperature sensor 16 can mainly be constituted, for example, of a thermocouple. A plurality of temperature sensors 16 are preferably arranged at an equal interval in a diametric direction. The temperature sensor 16 includes a spring mechanism, and the tip end of the sensor preferably contacts the inner surface of the concave portion 12A of the wafer chuck 12 with an elastic force. By the contact, the temperature sensor 16 securely detects the temperature of the wafer W via the wafer chuck 12.

In the present invention, a heat flow rate control mechanism for controlling a heat flow rate between the heater 13 and the cooler 14 is disposed. One embodiment of the heat flow rate control mechanism is shown in FIG. 1.

As the heat flow rate control mechanism, a cooler movement mechanism can be employed in which the cooler 14 is moved with respect to the heater 13, and the cooler 14 is brought in contact with the heater, or a gap is formed between the cooler and the heater.

The cooler movement mechanism in the heat flow rate control mechanism shown in FIG. 1 includes seal members 19, 19A and vacuum pump 21. That is, the seal members 19, 19A are arranged in an outer edge between the heater 13 and the cooler 14 and a peripheral edge of the temperature sensor 16. In the arrangement, as shown in FIG. 2, a groove 19B for containing the seal member is preferably formed in at least one of the heater 13 and cooler 14. These seal members form a sealed gap δ (e.g., 0.5 to 1 mm) between the heater 13 and the cooler 14. The through hole 14B opened in the gap δ is formed in the cooler 14. The vacuum pump 21 is connected to the through hole 14B via the piping 20. The changeover valve 22 operating via the PID controller 17 is attached to the piping 20. When the wafer W is cooled, the PID controller 17 PID-controls the changeover valve 22, and the piping 20 is changed from an atmospheric side to a vacuum pump 21 side. Thereby, the vacuum pump 21 brings the gap δ into a reduced pressure state. The cooler 14 is raised and closely stuck to the heater 13 by a suction force generated by pressure reduction. Conversely, when the wafer W is heated, the PID controller 17 PID-controls the changeover valve 22, and the piping 20 is changed from the vacuum pump 21 side to the atmospheric side. Thereby, the gap δ is returned to atmospheric pressure from the reduced pressure state. The cooler 14 is lowered and detached from the heater 13. In this manner, the cooler 14 is raised and lowered under control of the PID controller 17 as shown by a white arrow in FIG. 1.

While the cooler 14 is detached from the heater 13, the heat flow rate between the heater 13 and the cooler 14 is reduced. As a result, a cooling action to the heater 13 from the cooler 14 is reduced, and energy loss of the heater 13 can be minimized. Consequently, the heater can quickly heat the wafer over a broad range of temperature. Since the cooler 14 is detached from the heater 13, the cooler is not unnecessarily heated by the heater, and a refrigerant cooling ability is not wastefully lowered. Conversely, when the cooler 14 closely adheres to the heater 13, the heat generator 13A is turned off, the cooler 14 takes heat from the heater 13, and the temperature of the wafer W can rapidly be lowered. Additionally, in FIG. 1, reference numeral 23 denotes a cooler or an insulator.

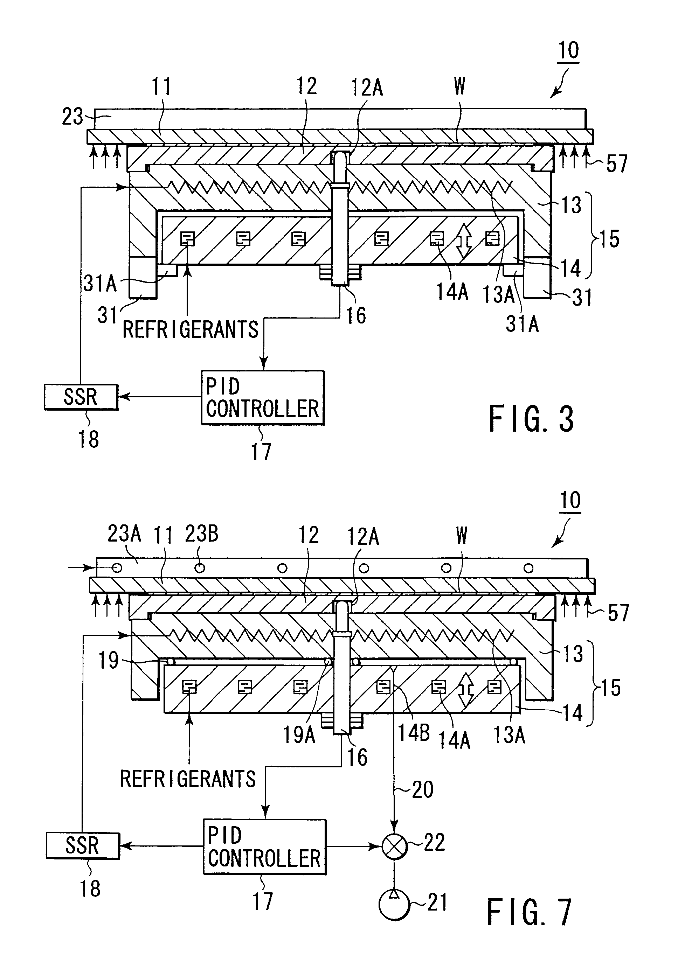

Another embodiment of the heat flow rate control mechanism will be described with reference to FIG. 3. In the mechanism, an electromotive mechanism for moving the cooler 14 with respect to the heater 13 is used. In FIG. 3, the cooler 14 is supported by an arm 31A disposed under the heater 13. An electromotive mechanism 31 is attached to a lower part of the heater 13, and raises/lowers the arm 31A. When the arm 31A is raised/lowered, the cooler 14 contacts the heater 13 during cooling, or is detached from the heater during heating and a gap is formed between the cooler and the heater.

A mechanism shown in FIG. 9 can also be used as the heat flow rate control mechanism for controlling the heat flow rate between the heater 13 and the cooler 14. The heat flow rate control mechanism has a structure for fixing the cooler 14 and heater 13 with a gap formed therebetween. In the fixing structure shown in FIG. 9, the cooler 14 is fixed to a hook 32 disposed on the lower end of the heater 13 via a screw 33. The gap between the cooler 14 and the heater 13 fixed in this manner can be connected to any one of a high heat conductive gas source 34, low heat conductive gas source 35 and vacuum pump 21. By this connection, the gap is set to be in a state filled with a high heat conductive gas during cooling of the wafer W, a state filled with a low heat conductive gas during heating of the wafer W, or an evacuated state. The heat flow rate in the gap can be controlled by this setting.

The wafer containing chamber will next be described. As shown in FIG. 4, the wafer containing chamber 50 has a flat rectangular shape. For example, a large number of rows and lines of wafer containing chambers 50 are arranged in a reliability testing housing (not shown) formed in a rack shape in a horizontal state. During the reliability test, the wafer W is attached in each wafer containing chamber 50 as the shell S held between the contacter 11 and the wafer chuck 12. That is, as shown in FIG. 4, the wafer containing chamber 50 has a temperature control chamber 51, and a connector chamber 52 disposed adjacent to the temperature control chamber 51. Both the chambers 51, 52 are shielded by an insulating wall (not shown). The insulating wall can be disposed so that the temperature of the connector chamber 52 is prevented from rising as much as possible. As described above, the temperature of the wafer W is set to a predetermined test temperature, and an ambient temperature of the wafer W is prevented from rising as much as possible in the temperature control chamber 51.

Cylinder mechanisms 54 are disposed in four corners of a base 53 of the temperature control chamber 51. Cylinder rod upper ends of the respective cylinder mechanisms 54 are connected to four corners of a press plate 55 disposed above the base 53. A clamp mechanism (not shown) is disposed on the back surface of the pressing plate 55. The shell S is received by the clamp mechanism. A connector and wiring board for connection to a tester (not shown) are disposed in the connector chamber 52.

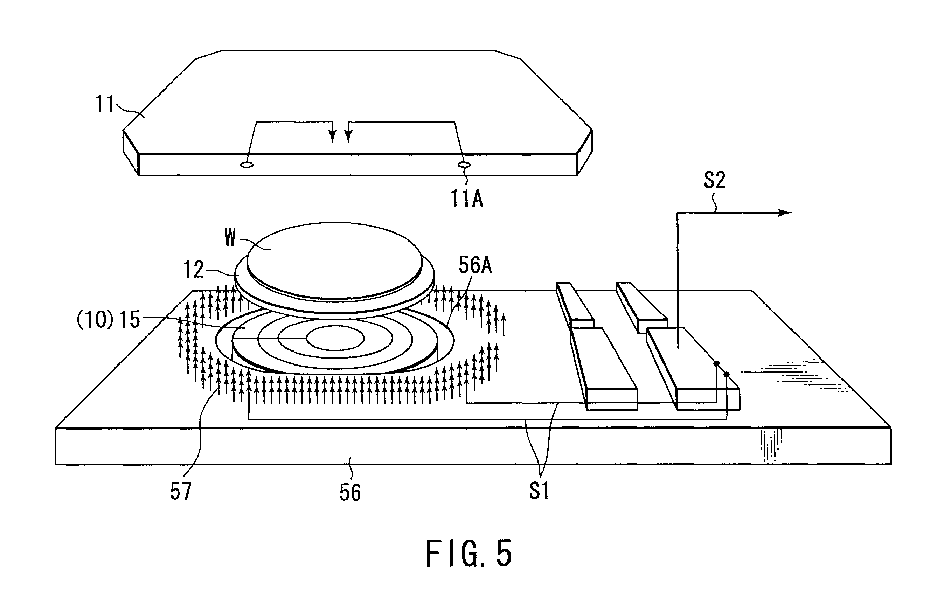

As shown in FIG. 4, a base plate 56 is disposed in parallel with the base 53 between the base 53 and the press plate 56 shown in FIG. 4. A circular hole 56A can be formed substantially in a middle of the base plate 56. The wafer temperature control apparatus 10 of the present embodiment is disposed inside the hole 56A. A diameter of the bottom jacket 15 constituted of the heater 13 and cooler 14 is slightly smaller than that of the hole 56A, and the upper surface of the jacket is substantially as high as the upper surface of the base plate 56. A shown in FIGS. 4 and 5, a large number of (e.g., 2,000 to 3,000) relay terminals (pogo pins) 57 for surrounding the bottom jacket 15 are arranged in a plurality of rows in an annular shape in the base plate 56. A large number of outer terminals (hereinafter referred to as "connection pads") 11A are disposed around an electrode pad (not shown) of the contacter 11. The pogo pins 57 are disposed opposite to the connection pads. While the pogo pins 57 contact the connection pads 11A, the pogo pins 57 are electrically connected to the connection pads 11A. Therefore, the shell S conveyed via a conveyor mechanism (not shown) is moved into the wafer containing chamber via the clamp mechanism in the temperature control chamber 51. The cylinder mechanism 54 is driven, and the shell S is lowered via the press plate 55 to reach the bottom jacket 15. The upper surface of the bottom jacket 15 contacts the back surface of the wafer chuck 12, and the connection pads 11A of the contacter 11 electrically contact the pogo pins 57. In this state the temperature of the wafer chuck 12 is controlled to be a predetermined test temperature (e.g., 150°C) by the bottom jacket 15. In FIG. 5, S1 and S2 denote test signals.

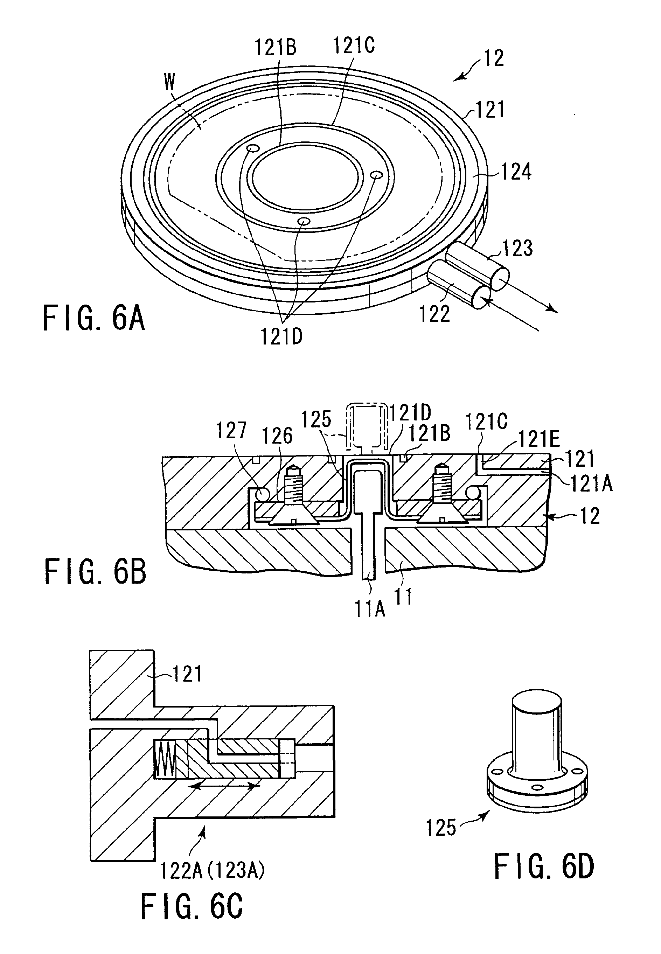

For the wafer chuck 12, for example as shown in FIGS. 6A, 6B, a chuck main body 121 formed in a disc shape will be integrated with the contacter 11 which holds the wafer W. A gas channel 121A is formed in the chuck main body 121 as shown in FIG. 6B. A gas supply tube 122 is connected to an inlet (opened in a main body peripheral surface) of the gas channel 121A, and a gas exhaust tube 123 is connected to an outlet (opened adjacent to the inlet of the main body peripheral surface) of the channel. A predetermined gas (chemically inactive gas such as nitrogen gas) is supplied/exhausted via both the tubes 122, 123.

As shown in FIGS. 6A, 6B, a plurality of annular grooves 121B, 121C are concentrically formed in the upper surface of the chuck main body 121 (FIG. 6 shows only two annular grooves). Openings 121E connected to the gas channel 121A are formed in a plurality of positions in these annular grooves 121B, 121C. A seal ring 124 formed of an elastic member high in flexibility such as silicon rubber is attached to the vicinity of the outer periphery of the upper surface of the chuck main body 121. When the contacter 11 is integrated with the wafer chuck 12, the inside is held to be hermetically sealed by the seal ring 124. The contacter 11 is superposed upon the wafer chuck 12, the pressure between the contacter and the wafer chuck is reduced via the gas supply tube 122 and gas exhaust tube 123, and the contacter and wafer chuck are integrated and prevented from being disassembled. Both tubes 122, 123 include valve mechanisms 122A, 123A shown in FIG. 6C. After the inactive gas (e.g., nitrogen gas) is supplied, the space between the wafer chuck 12 and the contacter 11 is evacuated and brought to the reduced pressure state. When a gas piping and vacuum exhaust tube (both are not shown) are removed from the respective gas supply/exhaust tubes 122, 123, springs of the valve mechanisms 122A, 123A act. By this spring, the valve moves to the right side from a position shown in FIG. 6C, shuts the outlet/inlet, prevents air inflow, and holds the inside at a reduced pressure state.

In the shell S of the integrated contacter 11 and wafer chuck 12, the electrode pads of the wafer W held by the wafer chuck 12 collectively contact the probes of the contacter 11, and the respective electrode pads are electrically connected to the probes.

As shown in FIGS. 6A and 6B, three holes 121D for passing pins P are formed between the annular grooves 121B and 121C of the wafer chuck 12. The diameter of the through hole 121D is larger than an outer diameter of the pin 11A. As shown in FIGS. 6B, 6D, a cylindrical silicon rubber film 125 with a closed tip end is disposed in the through hole 121D. A base end of the silicon rubber film 125 is screwed into a concave portion formed in the back surface of the chuck main body 121 via a packing 126 (e.g., of aluminum). An O ring 127 and silicon rubber film 125 attached to the outer periphery of the packing 126 hold the hermetic seal between the contacter 11 and the wafer chuck 12, and the reduced pressure state between the contacter and the chuck is maintained. Tip ends of three pins 11A are formed to be thick and round so that the silicon rubber film 125 is prevented from being damaged. A process of receiving the wafer W onto the wafer chuck 12 will be described. The main chuck three pins 11A rise, enter the through hole 121D of the wafer chuck 12, expand the silicon rubber film 125 during rising, project from the upper surface of the chuck main body 121 as shown by a dashed line of FIG. 6B, and receive the wafer W. The reduced pressure between the wafer chuck 12 and the contacter 11 is held as described above.

An operation will be described. As shown in FIG. 4, the wafer chuck 12, wafer W and contacter 11 are positioned by an alignment apparatus, and integrated to form the shell S, before the shell S is contained in the wafer containing chamber 50. A positioning process will be described. As shown in FIG. 6B, the wafer chuck 12 is disposed on a main chuck (not shown) of the alignment apparatus. After the wafer chuck 12 is disposed on the main chuck, the wafer W is conveyed onto the wafer chuck 12. At this time, in the main chuck, the three pins 11A rise, enter the through hole 121D of the wafer chuck 12, expand the silicon rubber film 125 during rising as shown by the dashed line of FIG. 6B, project from the upper surface of the wafer chuck 12, and wait for the wafer W. After the wafer W is disposed on the three pins 11A, the three pins 11A move back into the original positions in the main chuck. The wafer W is disposed on the wafer chuck 12. In parallel with this operation, the contacter 11 is disposed in a predetermined position above the main chuck, and aligned, the main chuck rises, and the wafer W and contacter 11 are integrated.

At this time, for example, the wafer chuck 12 is already brought to a state in which nitrogen gas replacement and evacuation are enabled via the gas supply/exhaust tubes 122, 123. The nitrogen gas is supplied from the gas supply tube 122, and air of the space between the wafer chuck 12 and the contacter 11 is replaced with nitrogen. When the nitrogen gas supply source is removed from the gas supply tube 122, the valve mechanisms 122A, 123A of the gas supply tube 122 operate to close the gas channel 121A. During evacuation via the gas exhaust tube 123, the nitrogen gas is evacuated from the space between the wafer chuck 12 and the contacter 11 via the gas channel 121A, and annular grooves 121B, 121C in the surface of the wafer chuck 12. Moreover, the electrode pads of the wafer W collectively contact those of the contacter 11, and the chips on the wafer can be tested via the contacter 11. The shell S is formed in this manner. The reduced pressure state between the wafer chuck 12 and the contacter 11 is securely held by the seal ring 124 and silicon rubber film 125.

Thereafter, the shell S is conveyed out of the alignment apparatus, and conveyed into the wafer containing chamber 50 (FIG. 4) by a conveyor mechanism (not shown). In the wafer containing chamber 50, the shell S is clamped by the clamp mechanism, and subsequently attached to the bottom jacket 15 by the press plate 55 driven by the cylinder mechanism 54 in four positions. When all the electrode pads 11A of the contacter 11 of the shell S electrically contact the corresponding pogo pins 57, the chips of the wafer W still in a wafer state can collectively be subjected to the reliability test.

When the reliability test starts, the wafer temperature control apparatus 10 operates. The wafer W is heated/controlled at the test temperature (ex. 150°C). When the temperature of the wafer W is raised, a power supply is connected to the heat generator 13A of the heater 13 via the relay 18 under control of the PID-controller 17. Since the changeover valve 22 PID-controlled by the PID controller 17 opens the piping 20 toward the atmosphere, the cooler 14 is detached from the heater 13. A cooling action to the heater 13 from the cooler 14 is reduced, and the wafer W can efficiently be heated at the test temperature via the wafer chuck 12 in a short time. The temperature of the wafer chuck 12 is measured by the temperature sensor 16. A measured detected temperature signal is outputted to the PID controller 17. The PID controller 17 compares the detected temperature with a target value (test temperature), and outputs a control signal to the relay 18 in accordance with a temperature difference. The PID controller 17 applies a power to the heat generator 13A in accordance with the difference, and thereby heats the wafer chuck 12 at the test temperature in a short time.

When the wafer chuck 12 reaches the test temperature, the PID controller 17 PID-controls the heat generator 13A based on the detected temperature signal of the temperature sensor 16, controls the supply power to the heat generator 13A to be substantially constant, and holds the wafer chuck 12 at the test temperature. During this process, the cooler 14 is separated from the heater 13 via the seal members 19, 19A. The refrigerant of the cooler 14 is not heated, which differs from the conventional art, and only cools the vicinity of the heater 13, so that no energy is wasted. After the reliability test finishes, to lower the temperature, the PID controller 17 turns off the power supply connected to the heat generator 13A via the relay 18, and switches the piping 20 to the vacuum pump 21 side from the atmospheric side via the changeover valve 22. Thereby, the pressure in the gap δ between the heater 13 and the cooler 14 is reduced, and the cooler 14 approaches and closely adheres to the heater 13. In this close adhering state, the cooler 14 can efficiently cool the heater 13. Since the refrigerant in the cooler 14 has a large temperature difference from the heater 13, the heater 13 can efficiently be cooled in a short time.

As described above, according to the present embodiment, the heat flow rate control mechanism for controlling the heat flow rate between the heater 13 and the cooler 14 is disposed. Therefore, during heating of the wafer W, the heat flow rate between the cooler 14 and the heater 13 is reduced, and the cooling action to the heat generator 13A from the cooler 14 is suppressed. Therefore, the heat generator 13A can continuously and efficiently heat the wafer W in the whole region, whose temperature can be controlled in a short time.

As one embodiment of the heat flow rate control mechanism, the cooler movement mechanism shown in FIG. 1 can be used. The cooler movement mechanism includes: the heater 13 including the heat generator 13A for heating/controlling the wafer chuck 12; the cooler 14 including the cooling means 14A which contacts the heater 13 via the seal members 19, 19A; the temperature sensor 16 which is passed between the heater and the cooler and inserted into the concave portion 12A of the wafer chuck 12; and the PID controller 17 for controlling the heat generator 13A in accordance with the detected temperature of the temperature sensor 16. The connection hole 14B connected to the gap δ formed between the heater 13 and the cooler 14 via the seal members 19, 19A is formed in the cooler 14, and connected to the vacuum pump 21 via the changeover valve 22. Additionally, the PID controller 17 controls the changeover valve 22 and sets the pressure of the gap δ to a reduced pressure or an atmospheric pressure. When the cooler 14 is attached to or detached from the heater 13 by the control of the changeover valve 22, the following action/effect is produced.

During heating of the wafer W, the cooling action to the heat generator 13A is reduced, and the wafer W can continuously and efficiently be heated in the whole region, whose temperature can be controlled in a short time. Furthermore, during heating of the wafer W, since the cooling action onto the heater 13 by the cooler 14 is reduced, all the energy from the heater 13 can be used for heating the wafer W. As a result, wasteful heat energy consumption is prevented, energy saving can be achieved, and response of temperature control can be enhanced. Since the insulator 23 is disposed above the wafer W, the wafer W is heated only from below, and therefore a degree of freedom of the contacter can be enhanced.

In the aforementioned embodiments, the case in which the wafer W is heated/controlled only from below has been described. A structure shown in FIG. 7 can also be used in which a cooler 23A is disposed instead of the insulator 23. In this structure, the wafer W can be cooled also from above. Therefore, when the temperature of the wafer is lowered, the wafer W can rapidly be cooled also with the cooler 14 disposed below the wafer. In FIG. 7, reference numeral 23B denotes a channel in which the refrigerant circulates. Other components are constituted in accordance with FIG. 1.

In the aforementioned embodiments, the case in which the vacuum pump 21 is used to control and detach/attach the cooler 14 and heater 13 has been described. However, the cooler 14 can also be attached to or detached from the heater 13 by another means, such as an electromotive mechanism shown in FIG. 3.
The PID controller 17 has been described as a temperature control technique, but another known conventional control technique can also be used. In the aforementioned embodiment, a conventionally known refrigerant other than water and ethylene glycol can also be used.

According to the present invention, there can be provided a wafer temperature control apparatus in which during the reliability test, the heat generator can efficiently be used, energy can be saved, and wafer temperature can quickly be controlled. Moreover, the heating temperature can continuously be controlled in all regions in which the temperature of the heat generator can be controlled.

## Claims

1. A temperature control apparatus including a temperature control mechanism including: an object (W) whose temperature is controlled; a heating member (13), disposed substantially in contact with the object, for heating the object; a cooling member (14), disposed opposite to the heating member with respect to the object, for cooling the object; at least one temperature sensor (16) for detecting a temperature of the object; and a controller (17) for controlling the temperature of the heating member and the cooling member based on the temperature detected by the temperature sensor,
said apparatus comprising a heat flow rate control mechanism (19, 19A, 20, 21, 22), (31, 31A), (32, 33, 20, 21, 22, 34, 35) for appropriately controlling a heat flow rate between the heating member and the cooling member.

2. The temperature control apparatus according to claim 1, **characterized in that** said heat flow rate control mechanism comprises a cooling member movement mechanism (19, 20, 21, 22), (31, 31A) for moving said cooling member with respect to said heating member, and bringing the cooling member in contact with the heating member, or forming a gap between the cooling member and the heating member.

3. The temperature control apparatus according to claim 2, **characterized in that** said object is a semiconductor wafer (W).

4. The temperature control apparatus according to claim 3, **characterized in that** said cooling member movement mechanism comprises a seal member (19) disposed between the heating member and the cooling member, and an exhaust mechanism (21) connected to a space between the heating member and the cooling member via a changeover valve (22).

5. The temperature control apparatus according to claim 3, **characterized in that** at least one of the heating member and the cooling member comprises a groove (19B) for containing said seal member.

6. The temperature control apparatus according to claim 3, **characterized in that** said cooling member movement mechanism comprises a mechanism for moving the cooling member by an electromotive mechanism (31, 31A).

7. The temperature control apparatus according to claim 3, **characterized in that** said cooling member movement mechanism comprises:
a movement mechanism comprising a seal member disposed between the heating member and the cooling member and an exhaust mechanism connected to a space between the heating member and the cooling member via a changeover valve; and
a mechanism for moving the cooling member by an electromotive mechanism.

8. The temperature control apparatus according to claim 3, **characterized in that** said controller comprises a PID adjusting meter (17).

9. The temperature control apparatus according to claim 3, **characterized by** further comprising:
a chuck top (12) comprising a laying surface on which said object is to be laid, and a lower surface which contacts the heating member,
wherein at least a tip end of said temperature sensor (16) is disposed in a concave portion (12A) formed in a lower surface of the chuck top.

10. The temperature control apparatus according to claim 1, **characterized in that** said heating member and said cooling member are disposed with a gap therebetween, and said heat flow rate control mechanism comprises a mechanism for bringing the gap between the heating member and the cooling member to at least one of a state filled with a high heat conductive gas (34), a state filled with a low heat conductive gas (35), and an evacuated state (21).
